Europäisches Patentamt

European Patent Office

Office européen des brevets

(11) Veröffentlichungsnummer: **0 201 878**
**A2**

(12) # EUROPÄISCHE PATENTANMELDUNG

(21) Anmeldenummer: **86106342.8**

(22) Anmeldetag: **07.05.86**

(51) Int. Cl.⁴: **H 03 K 17/687**
**H 03 K 17/08**

(30) Priorität: **10.05.85 DE 3516936**

(43) Veröffentlichungstag der Anmeldung:
**20.11.86 Patentblatt 86/47**

(84) Benannte Vertragsstaaten:
**AT BE CH DE FR IT LI NL SE**

(71) Anmelder: **Siemens Aktiengesellschaft Berlin und München**
**Wittelsbacherplatz 2**
**D-8000 München 2(DE)**

(72) Erfinder: **Hauenstein, Alfred, Dipl.-Ing. FH**
**Lipperheidestrasse 36**
**D-8000 München 60(DE)**

(54) **Schaltungsanordnung mit einem p-schaltenden n-Kanal MOS-Transistor.**

(57) Eine Schaltung, bei der sich ein n-Kanal MOS-Transistor ($T1$) zwischen Last ($R_L$) und Plus-Pol einer Betriebsspannungsquelle befindet, hat folgenden Treiberkreis: Parallel zum Schalttransistor ($T1$) und zur Last ($R_L$) ist jeweils ein RC-Glied (R1 C1 bzw. R2 C2 ; R1, R2≫$R_L$) geschaltet. Beide Kondensatoren haben einen gemeinsamen Anschluß ($S1$) auf Gate-Potential und sind spannungsbegrenzt ($U_{C1}$, $U_{C2}$ ≤ 12V). Das Gate liegt am Ausgang eines Inverters (Inv), der zwischen Source-Potential $U_{S1}$ und $U_{S1} + U_{C1}$ geschaltet werden kann. Parallel zu C1 liegt eine Diodenstrecke (D3 D4) und parallel zu C2 liegt ein Oszillator (Osz) mit einem Gegentaktausgang, der über einen Kondensator (C3) zwischen D3 und D4 geführt ist. Eine solche Ansteuerung benötigt keine externe Hilfsspannung, erlaubt einen statischen und dynamischen Schaltbetrieb sowie beliebig hohe Betriebsspannungen und läßt sich mit herkömmlichen Techniken weitgehend integrieren.

Hauptanwendungsgebiet: Schaltnetzteile, Tiefsetzsteller, Motorsteuerungen, Einschalten von Lasten in der Steuerungstechnik und im Kraftfahrzeug.

FIG 1

EP 0 201 878 A2

Siemens Aktiengesellschaft          Unser Zeichen
Berlin und München

**Schaltungsanordnung mit einem p-schaltenden n-Kanal MOS-Transistor.**

Die Erfindung bezieht sich auf eine Schaltungsanordnung gemäß dem Oberbegriff des Anspruchs 1. Eine Schaltung dieser Art wird in der DE-OS 32 09 070 beschrieben.

In vielen Fällen - beispielsweise bei Schaltnetzteilen in Halb- und Voll-Brückenschaltung, Tiefsetzstellern, Motorsteuerungen (Halb- und Voll-Brücke), im Kraftfahrzeug oder in der Steuerungstechnik - muß eine Last gegen den Plus-Pol der Betriebsspannung geschaltet werden. Verwendet man zum Schalten einen n-Kanal MOS-Transistor, so benötigt man zur vollen Aufsteuerung eine Gate-Spannung, die etwa 10V über der Betriebsspannung liegt.

Hierzu wird in der eingangs genannten Offenlegungsschrift eine Treiberschaltung diskutiert, bei der ein mit Wicklungen versehener, spannungserhöhender Oszillator aus der Betriebsspannung $U_B$ eine Steuerspannung $U_S$ ($U_S \geq U_B + U_{GS}$) liefert, die dann von einem µC-gesteuerten Vorstufentransistor durchgeschaltet wird. Eine solche Ansteuerung kann den Schaltkreis ausreichend niederohmig machen, ermöglicht einen statischen und dynamischen Betrieb und erlaubt auch hohe Betriebsspannungen; ihre Bauelemente kommen mit geringen Sperrspannungen aus und können am gleichen Potential arbeiten wie der Lastkreis. Nachteilig ist allerdings, daß eine Hilfsspannung erzeugt werden muß, und zwar mit einem aus Spulen und Kern aufgebauten Transformator, der aus einer Reihe von Gründen (mangelnde Integrierbarkeit, schwierige Montage, großer Platzbedarf und hohe Kosten) nach Möglichkeit vermieden werden sollte.

Les 1 Lk/25.4.1985

Spulenfreie Spannungsüberhöhungsschaltungen ("bootstrap") sind an sich bekannt; sie gestatten allerdings nur einen dynamischen Schaltbetrieb. Und eine besonders einfache Treiberschaltung wäre möglich, wenn man zu einem MOS-Transistor in p-Kanal-Technik übergehen würde. Dieser Weg kommt aber nur dann in Betracht, wenn Kostenüberlegungen keine wesentliche Rolle spielen.

Der Erfindung liegt die Aufgabe zugrunde, eine Schaltung der eingangs genannten Art so weiterzuentwickeln, daß sie - bei Wahrung aller günstigen Eigenschaften - ohne externe Hilfsspannung auskommt, keine aufwendigen, induktivitätsbehafteten Schaltmittel verlangt und insbesondere auch weitgehend integriert werden kann. Diese Aufgabe wird erfindungsgemäß durch eine Schaltungsanordnung mit den Merkmalen des Patentanspruchs 1 gelöst.

Die vorgeschlagene Schaltung zeichnet sich durch folgende Eigenschaften aus: Der Schalttransistor kann bis zu seinem minimalen Einschaltwiderstand gesteuert werden. Die Verlustleistung ist sowohl bei statischer als auch bei dynamischer Ansteuerung relativ gering. Aufgrund einer hohen Spitzenstromergiebigkeit sind dabei hohe Schaltfrequenzen möglich. Die Betriebsspannung kann ohne weiteres mehrere 100V betragen. Sämtliche Bauelemente benötigen Sperrspannungen $< 30V$, so daß man mit Standardtechnologien integrieren könnte.

Wenn der Lastwiderstand relativ große induktive oder kapazitive Anteile hat, empfiehlt es sich, den Schalttransistor durch eine dynamische Laststrombegrenzung zu schützen. Wie eine solche Schutzschaltung aus wenigen, mitintegrierbaren Bauelementen zusammengesetzt werden könnte, geht aus Anspruch 9 hervor.

Weitere vorteilhafte Ausgestaltungen und Weiterbildungen der Erfindung sind Gegenstand zusätzlicher Ansprüche.

- 3 -        VPA 85 P 1293  E

Der Lösungsvorschlag soll nun anhand eines bevorzugten Ausführungsbeispiels unter Bezugnahme auf die beigefügte Zeichnung näher erläutert werden. In den Figuren sind einander entsprechende Teile mit gleichen Bezugszeichen versehen. Es zeigen

Fig. 1    ein teilweise schematisch gehaltenes Schaltbild des Ausführungsbeispiels und

Fig. 2    in einem Blockschaltbild eine dynamische Strombegrenzung für eine Schaltung gemäß Fig. 1.

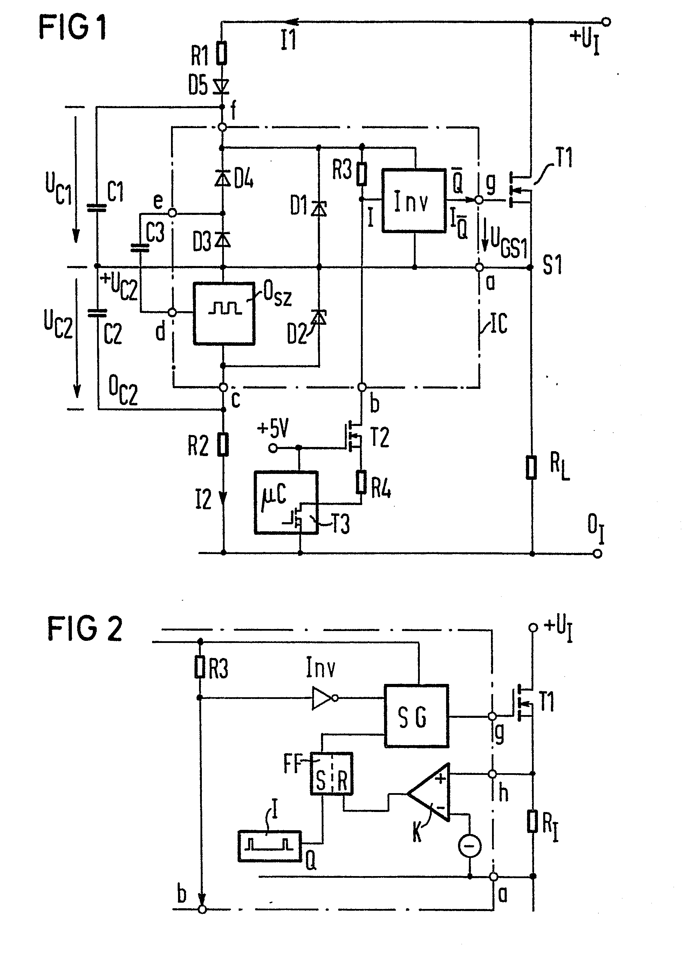

Die in Fig. 1 dargestellte Schaltung dient dazu, eine Last $R_L$ mit einem Widerstand in der Größenordnung von $10^2 \Omega$ sowohl statisch als auch dynamisch auf den Plus-Pol $+U_I$ einer nicht dargestellten, zwischen 250 V und 350 V liefernden Betriebsspannungsquelle zu schalten. Die Last liegt mit ihrer einen Seite am Minus-Pol $0_I$ der Spannungsquelle; zwischen der anderen Lastseite und dem Pol $+U_I$ befindet sich ein n-Kanal MOS-Transistor T1. Parallel zum Schalttransistor liegt eine Kette aus einem Widerstand R1 (50 k$\Omega$/2 W), einer Diode D5 und einem Kondensator C1 (220 nF/16 V), und quer zur Last $R_L$ ist ein weiteres, aus einem Kondensator C2 (220 nF/16 V) und einem Widerstand R2 (40 k$\Omega$/2 W) gebildetes Reihenglied geschaltet, wobei die Kondensatoren einen gemeinsamen, auf Gate-Potential des Schalttransistors liegenden Anschluß S1 haben. Außerdem liegen zu C1 eine 12 V-Zenerdiode D1 sowie eine Diodenkette (D3 mit einer Sperrspannung $\geq$ 15 V und D4 mit einer Sperrspannung $\geq$ 30 V) und zu C2 eine weitere 12 V-Zenerdiode D2 sowie ein 50 kHz-Oszillator parallel.

Die Gate-Elektrode des Schalttransistors T1 liegt am Ausgang $\overline{Q}$ eines Inverters Inv. Über R1 D5 wird die Versorgungsspannung $U_{C1}$ für den Inverter Inv aufgebaut. Der Eingang I des Inverters Inv wird über den Transistor T2 mit einer Spannung beaufschlagt. Der Teiler, der zwischen der Versorgungsspannungszuleitung und dem Minus-Pol $0_I$ liegt, enthält einen Widerstand R3 (10 k$\Omega$) sowie einen MOS-Transistor T2

($U_{DS} \geq$ 400V) in Reihe mit einem Widerstand R4 (1,8kΩ) und einem weiteren, in einen Mikroprozessor µC integrierten MOS-Transistor T3.

Die in der Figur von einem gestrichelten, mit den Eingängen a bis g versehenen Rechteck umschlossenen Bauelemente lassen sich integrieren.

Die Schaltung, bei der $R_{DSon}$ des Schalttransistors vernachlässigt werden darf, arbeitet wie folgt.

Wird die Betriebsspannung angelegt und ist T1 gesperrt, so fließt ein Strom I1 über R1 und D5 in C1, dessen Spannung $U_{C1}$ durch D1 auf 12V begrenzt ist, und weiter über $R_L$ auf $O_I$. Wegen $R_L \ll$ R1, R2 ist der über C2 und R2 fließende Stromanteil I2 vernachlässigbar gering und fällt an C2 praktisch keine Spannung ab. Solange die Strecke T2 R4 T3 hochohmig ist, hat die vom Inverter gelieferte Gate-Source-Spannung den Wert $U_{GS1} = 0$.

Zum Einschalten des Transistors T1 wird R4 gegen $O_I$ geschaltet, das heißt, das Potential am Invertereingang unter den Schwellwert abgesenkt. Daraufhin schaltet der Inverterausgang den $U_{GS1}$-Wert auf $+U_{C1} = +12V$, mit der Folge, daß der Schalttransistor niederohmig wird und sein Source-Potential auf $+U_I$ ansteigt. In dieser Phase kann das Potential am Eingang des Inverters unter das Spannungsniveau am Punkt S1 sinken; dieser Zustand ist unkritisch, weil T2, R4 und T3 strombegrenzend zusammengeschaltet sind.

Da C1 noch geladen ist, bleibt T1 zunächst noch eingeschaltet. Um diesen Schaltzustand bei Bedarf auch über längere Zeit hinweg aufrecht erhalten zu können, wird der Ladezustand von C1 über eine spezielle Nachladeschaltung (Osz, C2, C3, D2, D3 und D4) periodisch aufgefrischt, und zwar auf folgende Weise. Nach dem Einschalten von T1 läd sich C2 auf. Der Ladestrom I2 fließt von der Source S1 über C2 und R2 gegen $O_I$, wobei D2 die Kondensatorspannung $U_{C2}$ auf 12 V begrenzt. Sobald eine bestimmte Spannung an C2 anliegt, beginnt der Oszillator selbständig zu schwingen und C3 am Punkt d abwechselnd auf seine beiden Eingangsspannungen ($0_{C2}$, $+U_{C2}$) zu schalten. Liegt d an $0_{C2}$, so wird C3 über D3 von C2 aufgeladen; befindet sich d auf dem Potential $+U_{C2}$, läd C3 über D4 C1 nach, und zwar dann, wenn $U_{C1} < U_{C2} - U_{DS} - U_{D4}$ ist. Die Diode D5 verhindert dabei, daß C1 bei eingeschaltetem Transistor mit ca. 0,3 mA entladen wird; sie kann entfallen, und zwar vor allem dann, wenn C3 einen relativ hohen Wert hat.

Zum Ausschalten von D1 macht man den µC-Ausgang niederohmig. Dann schaltet der Inverterausgang die Spannung $U_{GS1}$ kurz, mit dem Effekt, daß T1 gesperrt und C1 in der geschilderten Weise aufgeladen wird.

Die Treiberschaltung hat eine Gesamtverlustleistung, die in allen Betriebszuständen höchstens 2 W beträgt. Der vom Inverter an den Schalttransistor gelieferte Strom $I_{\overline{Q}}$ hat Werte von mindestens 200 mA.

Die geschilderte Schaltung läßt sich, wie Fig. 2 zeigt, relativ einfach um eine dynamische Laststrombegrenzung erweitern. Zu diesem Zweck ist der erste Eingang des Schaltgliedes SG (UND-Gatter) auf ein Flip Flop FF geführt, das seinerseits von einem Impulsgeber G und einem Komparator K beschickt wird. Der Komparator empfängt an seinem Negativ-Eingang eine Referenzspannung von beispielsweise +300 mV und an seinem Positiv-Eingang einen Spannungswert, der an einem in Reihe zur Last $R_L$ liegenden Widerstand $R_I$ abfällt. Wenn dieser Spannungsabfall größer ist als die Referenzspannung, setzt der Komparator das Flip Flop zurück; damit wird T1 gesperrt, da dem zweiten Eingang des Schaltgliedes SG ein Inverter Inv vorgeschaltet ist. Dieser Inverter Inv bewirkt, daß die Signale des Punktes b invertiert auf das Gate des Transistors Tl geschaltet werden, wenn der erste Eingang des Schaltgliedes SG durch das Flip Flop FF auf H-Potential liegt. Nach einer vom Impulsgeber vorgegebenen Zeit wird FF wieder gesetzt, so daß Tl wieder auftastet. Der Vorgang wiederholt sich solange, bis die Ursache des Überstromes beseitigt ist. Flip Flop, Komparator, Referenzspannungsquelle und Impulsgeber, der eventuell vom Oszillator abgeleitet werden könnte, ließen sich bei Bedarf mit integrieren.

Patentansprüche

1. Schaltungsanordnung mit

1) einer Last (R$_L$) im Kreis einer Gleichspannungsquelle;

2) einem n-Kanal MOS-Schalttransistor (T1) zwischen Last (R$_L$) und Plus-Pol der Gleichspannungsquelle;

3) einer Ansteuerschaltung, die aus der Spannung (+U$_I$) am Plus-Pol der Gleichspannungsquelle eine Ansteuerspannung für den Schalttransistor (T1) gewinnt;

d a d u r c h   g e k e n n z e i c h n e t,   daß die Ansteuerschaltung folgendermaßen aufgebaut ist:

4) parallel zur Drain-Source-Strecke des Schalttransistors (T1) liegt ein erstes RC-Glied aus einem Widerstand (R1) in Reihe zu einem spannungsbegrenzten Kondensator (C1);

5) parallel zur Last (R$_L$) liegt ein zweites RC-Glied (R2, C2), und zwar so, daß beide spannungsbegrenzte Kondensatoren (C1, C2) einen gemeinsamen Anschluß (S1) haben;

6) die Gate-Elektrode des Schalttransistors (T1) ist mit dem Ausgang eines Inverters (Inv) verbunden, der mit einer zwischen dem Widerstand (R1) und dem Kondensator (C1) des ersten RC-Gliedes abgegriffenen Spannung versorgt wird, und mit seinem Eingang auf unterschiedliche, den Inverterausgang umschaltende Potentiale gelegt werden kann;

7) parallel zum Kondensator (C1) des ersten RC-Gliedes liegt eine Reine mit zwei Gleichrichter (D3, D4) und

8) parallel zum Kondensator (C2) des zweiten RC-Gliedes liegt ein Oszillator (Osz) mit einem Ausgang, der über einen weiteren Kondensator (C3) zwischen die beiden Reihen-Gleichrichter (D3, D4) geführt ist.

2. Schaltungsanordnung nach Anspruch 1, d a d u r c h   g e k e n n z e i c h n e t, daß der Invertereingang auf einen Spannungsteiler geführt ist, der zwischen dem Versorgungsspannungseingang des Inverters und dem Minus-Pol der Gleichspannungsquelle liegt und polseitig einen schaltbaren Widerstand aufweist.

3. Schaltungsanordnung nach Anspruch 2, d a d u r c h g e k e n n z e i c h n e t, daß der schaltbare Widerstand eine Kette aus einem ersten Transistor (T2), einem Widerstand (R4) und einem zweiten Transistor (T3) enthält, wobei die Gate-Elektrode des ersten Transistors (T2) auf eine feste Spannung gelegt ist, der zweite Transistor (T3) an der Spannung ($0_I$) des Minus-Pols der Spannungsquelle liegt und beide Transistoren (T2, T3) vorzugsweise in einer MOS-Technik ausgeführt sind.

4. Schaltungsanordnung nach Anspruch 3, d a d u r c h g e k e n n z e i c h n e t, daß der zweite Transistor (T3) Bestandteil eines Mikroprozessors (µC) ist.

5. Schaltungsanordnung nach einem der Ansprüche 1 bis 4, d a d u r c h g e k e n n z e i c h n e t, daß die Kondensatoren (C1, C2) beider RC-Glieder jeweils durch eine querliegende Zenerdiode (D1, D2) spannungsbegrenzt sind.

6. Schaltungsanordnung nach einem der Ansprüche 1 bis 5, d a d u r c h g e k e n n z e i c h n e t, daß sich zwischen dem Widerstand (R1) und dem Kondensator (C1) des ersten RC-Gliedes eine Diode (D5) befindet.

7. Schaltungsanordnung nach einem der Ansprüche 1 bis 6, d a d u r c h g e k e n n z e i c h n e t, daß gilt: R1, $R2 \geq 10^2 R_L$ und insbesondere R1, $R2 \geq 10^3 R_L$.

8. Schaltungsanordnung nach einem der Ansprüche 1 bis 7, d a d u r c h g e k e n n z e i c h n e t, daß der Inverter (Inv), der Oszillator (Osz), die Gleichrichterreihe (D3, D4) und ggf. auch die Zenerdioden (D1, D2) sowie der zwischen dem Versorgungsspannungseingang und dem Eingang des Inverters (Inv) befindliche Teil des Spannungsteilers (R3) zu einem Baustein integriert sind.

9. Schaltungsanordnung nach einem der Ansprüche 1 bis 8, d a d u r c h g e k e n n z e i c h n e t , daß sie ein Schaltglied (SG) aufweist, dessen zweiter Eingang über einen Inverter (Inv) mit einem Punkt b verbunden ist und dessen erster Eingang auf ein Flip Flop (FF) geführt ist, dessen erster Eingang mit einem Impulsgeber (I) und dessen zweiter Eingang mit einem Komparator (K) verbunden ist, wobei der Komparator (K) das Flip Flop (FF) zurücksetzt und damit den Schalttransistor (T1) sperrt, wenn der Spannungsabfall an einem Reihenwiderstand ($R_I$) im Lastkreis einen kritischen Wert überschreitet, und der Impulsgeber (I) das Flip Flop (FF) nach einer vorgegebenen Zeit wieder setzt und damit den Schalttransistor (T1) wieder aufsteuert.

10. Schaltungsanordnung nach Anspruch 9, d a d u r c h g e k e n n z e i c h n e t , daß der Impulsgeber (I) vom Oszillator (Osz) abgeleitet ist.

11. Schaltungsanordnung nach Anspruch 9 oder 10, d a - d u r c h g e k e n n z e i c h n e t , daß Flip Flop (FF), Impulsgeber (I) und Komparator (K) integriert sind.

## Bezugszeichenliste

| | |
|---|---|
| C1, C2, C3 | Kondensator |
| D1, D2 | Zenerdiode |
| D3, D4, D5 | Diode |
| FF | Flip-Flop |
| I | Impulsgeber |
| I1, I2 | Teilstrom |
| IC | integrierte Schaltung |
| $I_{\bar{Q}}$ | Inverterstrom |
| Inv | Inverter |
| K | Komparator |
| $0_I$ | Minuspol der Spannungsquelle |
| $0_{sz}$ | Oszillator |
| $\bar{Q}$ | Inverterausgang |
| S1 | Anschluß auf T1-Gate-Potential |
| R1, R2, R3, R4, RI | Widerstand |
| $R_L$ | Last |
| T1 | n-Kanal-MOS-Schalttransistor |
| T2, T3 | MOS-Transistor |
| $U_{C1}$, $U_{C2}$ | Spannung der Kondensatoren C1, C2 |
| $U_I$ | Betriebsspannung |
| µC | Mikroprozessor |
| a, b, c, d, e, f, g | Eingänge von IC |
| SG | Schaltglied |

1/1

FIG 1

FIG 2